# EUROPEAN PATENT SPECIFICATION

(11) **EP 0 624 948 B1**
(45) Date of publication and mention of the grant of the patent: **02.09.1998**
(21) Application number: 94302453.9
(22) Date of filing: 07.04.1994
(51) Int. Cl.: H03J 1/00

(54) **Tuner for radio data system**
Tuner für Rundfunk-Daten-System
Tuner pour système de données de radio

(30) Priority: 12.04.1993 JP 18077/93
(43) Date of publication of application: 17.11.1994
(73) Proprietor: PIONEER ELECTRONIC CORPORATION, Meguro-ku Tokyo-to (JP)
(72) Inventor: Suenaga, Shoji, c/o Pioneer Electronic Corp., Tsurugashima-shi, Saitama-ken (JP)
(74) Representative: Brunner, Michael John

(56) References cited:
- EP-A- 0 386 835
- US-A- 5 020 139
- PATENT ABSTRACTS OF JAPAN vol. 16, no. 389 (E-1250) 19 August 1992 & JP-A-04 126 415 (ALPINE ELECTRON INC)

## Description

This invention relates to a RDS (Radio Data System) tuner for receiving signal according to RDS, and more particularly to a RDS tuner capable of controlling a traffic report waiting function.

There is known Radio Data System which broadcasts various programs and information. In this system, information relating to the program is multiplexed with the signal of the program and the multiplexed signal is modulated and transmitted. At reception side, the transmitted signal is demodulated and information relating to the program is decoded so that user can select a favorite program by referring to information decoded. In RDS in practice in Europe, various data (hereinafter referred to as "RDS data") such as Program Identification code (PI code), Traffic Program identification code (TP code), list of Alternative Frequencies (AF list) representing list of frequencies of broadcasting stations transmitting the same program, Program Service name (PS name) representing names of broadcasting stations or networks, are multiplexed with main program and transmitted in a form of FM radio wave. A RDS tuner installed in automobile receives and demodulates signal of RDS (hereinafter referred to as "RDS signal") transmitted, decodes RDS data and performs various special functions. One of them is an Alternative Frequency (AF) function in which a station in a best transmission condition is searched out of a plurality of stations transmitting the same program by utilizing PI code and AF list, during driving of the automobile, and the tuner is automatically tuned to the station in best transmission condition. Another one is a traffic report waiting function in which commence of traffic report is constantly monitored by utilizing TP code and Traffic Announcement identification code (TA code), and the tuner is automatically tuned to the traffic report when it begins. According to the traffic report waiting function, commence of traffic report is constantly monitored while user is listening to other sound source such as a tape deck playing music from a cassette, and the system switches the sound source from the tape deck to the traffic report when it begins.

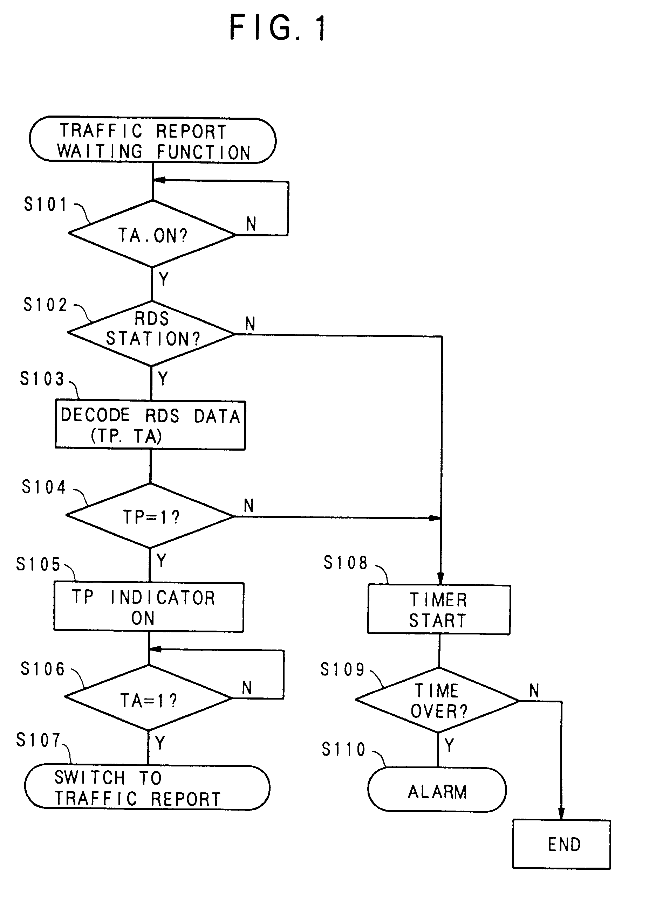

FIG. 1 shows an operation of the traffic report waiting function. As shown in FIG.1, the operation start with a manipulation of function selection button TA in step S101. In step S102, it is discriminated whether the station currently tuned is a RDS station or not. If the discrimination in step S101 results in YES, RDS data including TP code and TA code is decoded from demodulated signal in step S103. Then, it is discriminated in step S104 whether the station currently tuned presents traffic report or not (i.e., TP code equals to 1 or not). If the discrimination in step S104 results in YES, a TP indicator is turned ON to inform user that the station currently tuned presents traffic report, in step S106. Then, when traffic report begins (i.e., TA code becomes equal to 1), the sound source is switched to the traffic report in step S107. Alternately, if the station currently tuned is not a RDS station or does not present traffic report (i.e., TP is not equal to 1), an alarm is issued after a predetermined time has passed, in steps S108 - S110.

Generally, a RDS tuner installed in an automobile has a plurality of preset keys to register frequencies of various broadcasting stations in advance so that user can listen to a program of desired channel by one-touch operation. Additionally, in recent days, a portable CD player is installed in the automobile and connected to the RDS tuner via an FM modulator so that not only broadcasting programs but music reproduced from CD can be enjoyed by modulating a signal reproduced from CD to a predetermined frequency and supplying the modulated signal to the tuner. In this case, the frequency of the signal modulated by the FM modulator is registered in a position of one of the preset keys of the tuner, and user can listen to the music of CD by selecting the preset key in the same manner as the broadcasting programs. However, in the case of listening to CD in the above manner, an alarm is issued because no RDS data is multiplexed into the modulated signal from the CD player (see. FIG. 1, steps S108 - S110). Accordingly, when user listens to music from CD via the RDS tuner in the above described manner, he or she has to cancel the selection of the traffic report waiting function. However, once the traffic report waiting function is cancelled, the cancellation is valid to other channels registered in other preset keys. Therefore, user has to set the traffic report waiting function once again when he or she wishes to use it, and it is very troublesome.

EP-A-0386835 discloses an RDS receiver with channel selection.

It is an object of the present invention to provide a RDS tuner in which the traffic report waiting function is easily invalidated when non-RDS source is tuned, and the invalidation of the function does not affect the function of other channels.

According to the present invention which is defined by the appended claims, there is provided a tuner for Radio Data System characterised by:
receiving means for receiving signals modulated to a plurality of frequencies each allocated to one of a plurality of channels;
channel selecting means for selecting one of the plurality of channels by manipulating an input portion corresponding thereto;
reproducing means for reproducing signal modulated to the frequency corresponding to the channel selected by the channel selection means; and
function setting means for setting special function relating to RDS for the plurality of channels, characterised in that said function setting means invalidates the special function with respect to only some of the plurality of channels.

In the drawings:
Fig. 1 is a flowchart illustrating an operation of traffic report waiting function of conventional RDS tuner;
Fig. 2 is a block diagram illustrating a concept of the present invention;
FIG. 3 is a diagram illustrating a construction of a RDS tuner according to an embodiment of the present invention;
FIG. 4 is a flowchart illustrating an operation of preset key control according to the embodiment of the present invention; and
FIG. 5 is a flowchart illustrating another operation for invalidating the traffic report waiting function.

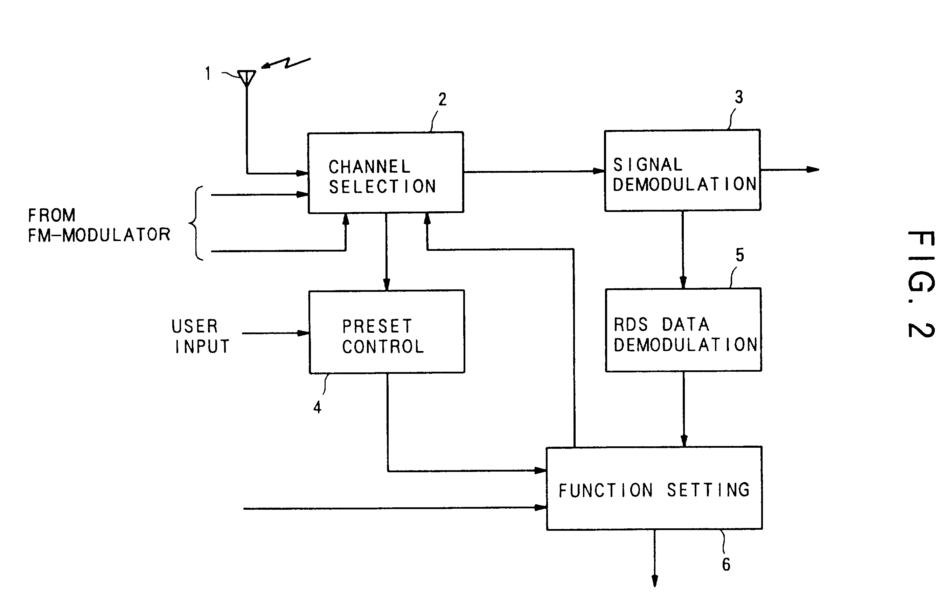

Firstly, a concept of the present invention will be described with reference to FIG. 2. As shown in FIG. 2, the RDS tuner according to the present invention includes an antenna 1, a channel selection unit 2, a signal demodulation unit 3, a preset control unit 4, a RDS data demodulation unit 5 and a function setting unit 6. The antenna 1 receives an RF signal transmitted and supplies the received signal to the channel selection unit 2. The channel selection unit 2 receives not only the output of the antenna 1 but signal from other source such as CD, cassette tape deck, whose reproduced signal is frequency modulated by an FM modulator. The channel selection unit 2 selects a channel from a plurality of broadcasting stations and sound sources, and supplies the signal of the selected channel to the signal demodulation unit 3. The signal demodulation unit 3 demodulates the supplied signal into a reproduction signal such as a stereo signal and supplies it to the RDS data modulation unit 5. The RDS data demodulation unit 5 extracts and decodes RDS data multiplexed in the transmitted signal and supplies it to the mode setting unit 6. The preset control unit 4 registers a plurality of frequencies of broadcasting stations or FM modulators in response to external instructions, and sends information of registered frequencies to the channel selection unit 2. In addition, the preset control unit 4 monitors time period that preset key is pressed (hereinafter referred to as "pressing time") and invalidates the traffic report waiting function of only the channel selected by the preset key when the pressing time is longer than a predetermined time period.

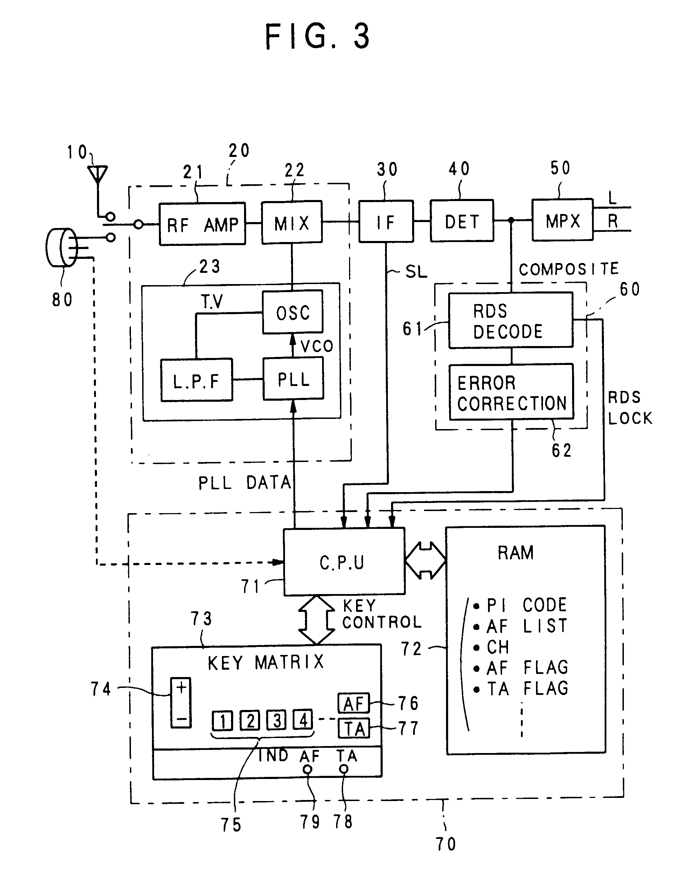

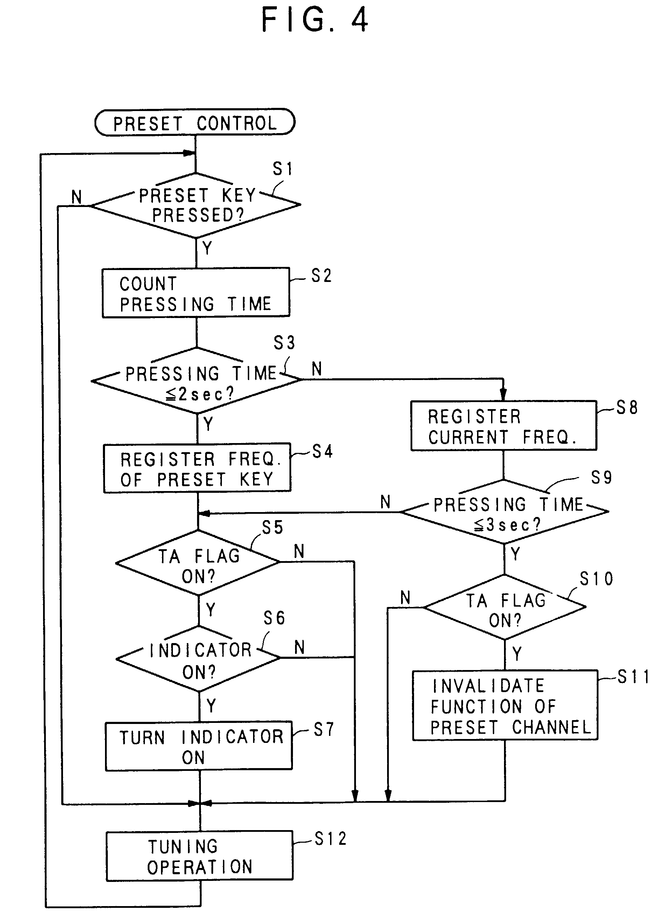

Next, a preferred embodiment of the present invention will be described below with reference to FIGS. 3 and 4. FIG. 3 illustrates a construction of RDS tuner according to the present invention. As shown in FIG. 3, the RDS tuner roughly includes an antenna unit 10, a front-end unit 20, an intermediate frequency (IF) amplifier unit 30, a detector 40, a stereo demodulation unit (MPX) 50, a RDS demodulation circuit 60, and a control unit 70. The front-end unit 20 includes an RF amplifier 21, a mixer 22 and a local oscillator 23. The front-end unit 20 selects and amplifies an RF signal of a frequency instructed by the control unit 70 while attenuating the signal of other frequencies, and converts it to an IF signal. To the RF amplifier 21, one of the signal received by the antenna unit 10 and the signal output from an FM modulator 80 is selectively supplied. The IF signal output from the mixer 22 is amplified by the IF amplifier 30, and a stereo signal is restored from the IF signal in the detector 40 by FM detection. The stereo signal thus obtained in the detector 40 is called "composite signal" and is separated into an L-channel signal and an R-channel signal in the stereo demodulation circuit 50. From the composite signal, RDS data multiplexed therein is extracted by the RDS demodulation circuit 60. In the RDS demodulation circuit 60, RDS data is decoded by the RDS decoder 61 and the error correction is conducted by the error correction circuit 62. Then, the RDS data is supplied to the control unit 70. The control unit 70 includes a CPU 71, a RAM 72 and an input unit 73, and performs various processing under the control of the CPU 71. The input unit 73 is equipped with a matrix portion of input keys which includes a frequency selection switch 74, preset keys 75, a key 76 for setting the alternative frequency (AF) function, a key 77 for setting Traffic Report (TA) waiting function, and indicators 78 and 79 indicating whether the functions are active or not.

In a channel presetting, the CPU 71 sets frequency input to by the frequency selection switch 74 to one of the positions of preset keys in the front-end unit 20. In addition, the CPU 71 monitors RDS data transmitted and stores the RDS data including PI code and AF list into the RAM 72. In this case, when the switch 76 for the Alternative Frequency function is turned ON, the CPU 71 turns the AF flag in the RAM 72 ON and light the indicator 79 of the Alternative Frequency function. Further, the CPU 71 monitors the level SL of the output from the IF amplifier 30. When the level of the signal SL becomes lower than as predetermined allowable level, the CPU 71 detects and compares levels of signal SL of broadcasting stations in the AF list, and selects a station whose level of signal SL is highest. This operation is called as "PI SEEK".

When the switch 77 for traffic report waiting function is turned ON, the CPU 71 sets the TA flag in the RAM 72 ON and turns the indicator 78 of traffic report waiting function ON. In addition, the CPU 71 monitors the TP code and the TA code and switches the sound source to the traffic report when it begins. Further, The CPU 71 monitors the manipulation of the preset keys 75, and performs the preset control including registration of frequency in the RAM 72 and setting of the registered frequency in the front-end unit 20.

FIG. 4 illustrates operation of the preset control. When one of the preset keys 75 is pressed in step S1, the CPU 71 counts the pressing time in step S2. According to the pressing time, the CPU 71 executes the following operations.
(a) In the case where the pressing time is shorter than 2 seconds:
   In this case, the CPU 71 reads out the frequency data, from the RAM 72, registered at the position corresponding to the preset key pressed by the user, and alters the frequency of currently tuned channel to the frequency read out from the RAM 72 in step S4. Then, the CPU 71 checks the TA flag to discriminate whether the switch 77 for the traffic report waiting function is ON state or not in step S5. Then, the CPU 71 discriminates whether the indicator 78 of the traffic report waiting function is lighting or not in step S6. If the TA flag is ON state and the indicator 78 is not lighting, the CPU 71 turns the indicator 78 ON.
(b) In the case where the pressing time is longer than 2 seconds:
   In this case, the CPU 71 registers the frequency data of the currently tuned channel in the RAM 72 at the position corresponding to the preset key pressed by user in step S3 and S8. Then, if the pressing time is shorter than 3 seconds, the CPU 71 checks TA flag and the indicator 78, similarly to the case of (a), in steps S5 - S7.
(c) In the case where the pressing time is longer than 3 seconds:
   In this case, the CPU 71 executes the alteration of registered frequency, similarly to the above case (b), in steps S3 and S8. Then, the CPU 71 checks the TA flag in step S10. If the TA flag is ON state, the CPU 71 invalidates the traffic report waiting function of only the channel corresponding to the preset key that is pressed by user, and turns off the indicator 78 in step S11.

As described above, according to this embodiment, the traffic report waiting function is invalidated by pressing the preset key of the channel whose function is to be invalidated for more than 3 seconds, even if the switch 77 is in ON state. At this time, however, the traffic report waiting function of channels except for the one corresponding to the pressed key are not invalidated and still active. Therefore, if other keys are pressed for more than 2 seconds to alter the receiving channel thereof, the traffic report waiting function of those channels are still maintained active. In this view, when an user listening to the music from the FM modulator 80 wishes to invalidate the traffic report waiting function, the user can invalidate the function of only the channel of the RF modulator 80, without invalidating the function of the other channels, by simply pressing the preset key of objective channel.

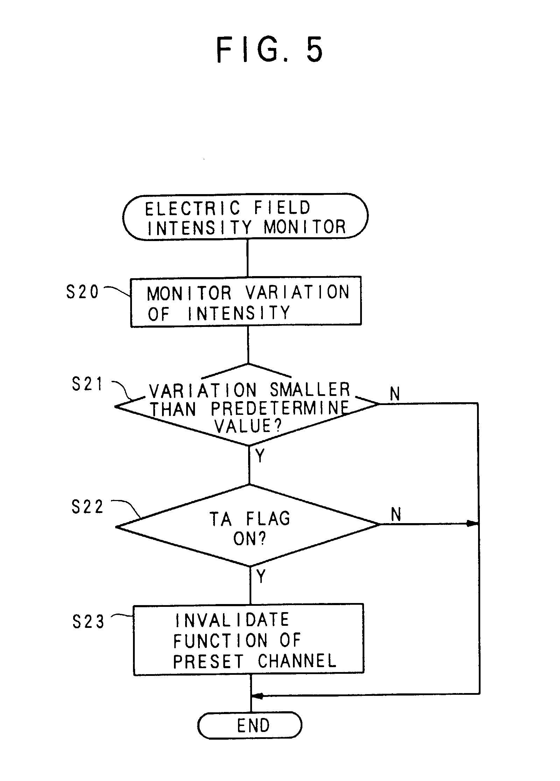

In the above described embodiment, the traffic report waiting function is invalidated by manipulating the preset key. Alternately, it is possible to invalidate the function in consideration of intensity of electric field of input signal. This method is described in more detail with reference to FIG. 5. In respect to intensity of the electric field, the intensity of electric field of the signal received by the antenna is unstable because it is transmitted by via air. In contrast, the intensity of electric field of the signal input from the FM modulator is constant and stable because it is transmitted via a line. Accordingly, by monitoring the variation of the intensity of electric field, it is possible to discriminate whether the signal is supplied from the antenna or from the FM modulator. FIG. 5 describes this operation. In the level monitor operation, firstly, the variation of the intensity of electric field is monitored for a predetermined time period with respect to signals of the every channels in step S20. If it is discriminated that the variation of the intensity of electric field is within a predetermined range in step S21, then it is further discriminated whether the TA flag indicating the status of traffic report waiting function is ON state or not in step S22. If the TA flag is OFF state, the traffic report waiting function of the channel is invalidated and the indicator 78 of traffic report waiting function is turned OFF in step S23. When the variation of the intensity of electric field is out of the predetermined range or when the TA flag is OFF state in step S22, the operation is terminated.

Alternately, it is possible to supply a control signal from the FM modulator 80 to the CPU 71, as indicated by the dotted line in FIG. 3, to notify the CPU 71 that the signal is supplied from the FM modulator 80. In this case, the traffic report waiting function is invalidated when the control signal is detected by the CPU 71.

The above description is directed to the invalidation of the traffic report waiting function, however, the concept of the present invention is applicable to the Alternative Frequecy function or other special functions. In the Alternative Frequency function, the PI SEEK is performed when RDS data is not included in the signal. Therefore, it is possible to invalidate the function in the same manner. Further, it is also possible to cancel all special functions relating to RDS.

As described above, according to the present invention, it is possible to invalidate the traffic report waiting function, by simply pressing the preset key, only for the channel which include no RDS data. Therefore, the operation of the invalidation is simplified, and the operation does not affect the function of the other channels allocated to other broadcasting stations.

## Claims

1. A tuner for Radio Data System characterised by:
receiving means (10,20) for receiving signals modulated to a plurality of frequencies each allocated to one of a plurality of channels;
channel selecting means (73) for selecting one of the plurality of channels by manipulating an input portion (75) corresponding thereto;
reproducing means (40,50) for reproducing signal modulated to the frequency corresponding to the channel selected by the channel selection means; and
function setting means (71) for setting special function relating to RDS for the plurality of channels, characterised in that said function setting means invalidates the special function with respect to only some of the plurality of channels.

2. A tuner according to claim 1, wherein said special function comprises a traffic report waiting function for monitoring reception of traffic report on the basis of the signal received by the receiving means, and interrupting the reproduction by the reproducing means and reproducing the traffic report when the reception of the traffic report is detected.

3. A tuner according to claims 1 or 2, wherein said function setting means invalidates the special function with respect to the channel whose input portion is manipulated more than a predetermined time period.

4. A tuner according to claims 1 or 2, wherein said function setting means invalidates the special function with respect to the channel variation of signal intensity of which is within a predetermined range.

5. A tuner according to claims 1 or 2, further comprising an FM modulator (80), and wherein said function setting means invalidates the special function with respect to the channels receiving signal from the FM demodulator.

## Patentansprüche

1. Ein Tuner für Rundfunk-Daten-System, **gekennzeichnet durch:**
eine Empfangseinrichtung (10, 20) zum Empfang von Signalen, die mit einer Mehrzahl von Frequenzen moduliert sind, von denen jede einem einer Mehrzahl von Kanälen zugeteilt ist;
eine Kanalauswähleinrichtung (73) zur Auswahl eines aus der Mehrzahl von Kanälen, indem ein dazu entsprechender Eingabesabschnitt (75) betätigt wird;
eine Wiedergabeeinrichtung (40, 50) zur Wiedergabe des Signals, das auf die Frequenz moduliert ist, die dem Kanal entspricht, der durch die Kanalauswähleinrichtung ausgewählt worden ist, und
eine Funktionseinstelleinrichtung (71), um eine spezielle Funktion, die sich auf das Rundfunk-Daten-System bezieht, für die Mehrzahl der Kanäle einzustellen, dadurch gekennzeichnet, daß die genannte Funktionseinstelleinrichtung die spezielle Funktion in bezug auf nur einige der Mehrzahl von Kanälen ungültig macht.

2. Ein Tuner gemäß Anspruch 1, wobei die genannte spezielle Funktion eine Verkehrsbericht-Wartefunktion umfaßt, um den Empfang eines Verkehrsberichts auf der Grundlage des Signals zu überwachen, das von der Empfangseinrichtung empfangen wird, und wobei die Wiedergabe durch die Wiedergabeeinrichtung unterbrochen und der Verkehrsbericht wiedergegeben wird, wenn der Empfang des Verkehrsberichts erfaßt wird.

3. Ein Tuner gemäß Anspruch 1 oder 2, wobei die genannte Funktionseinstelleinrichtung die spezielle Funktion in bezug auf den Kanal ungültig macht, dessen Eingabeabschnitt länger als eine vorbestimmte Zeitdauer betätigt worden ist.

4. Ein Tuner gemäß Anspruch 1 oder 2, wobei die genannte Funktionseinstelleinrichtung die spezielle Funktion in bezug auf die Kanaländerung der Signalintensität ungültig macht, die innerhalb eines vorbestimmten Bereiches ist.

5. Ein Tuner gemäß Anspruch 1 oder 2, der des weiteren ein FM Modulator (80) umfaßt, und wobei die genannte Funktionseinstelleinrichtung die spezielle Funktion in bezug auf die Kanäle ungültig macht, die ein Signal von dem FM Demodulator erhalten.

## Revendications

1. Un syntoniseur pour le système appelé Radio Data System, caractérisé par :
des moyens de réception (10, 20) pour recevoir des signaux modulés à un ensemble de fréquences, chacune d'elles étant allouée à un canal d'un ensemble de canaux;
des moyens de sélection de canal (73) pour sélectionner l'un des canaux de l'ensemble de canaux, en manipulant une section d'entrée (75) qui lui correspond;
des moyens de reproduction (40, 50) pour reproduire un signal modulé à la fréquence correspondant au canal qui est sélectionné par les moyens de sélection de canal; et
des moyens d'établissement de fonction (71) pour établir une fonction spéciale concernant le RDS pour l'ensemble de canaux, caractérisé en ce que les moyens d'établissement de fonction invalident la fonction spéciale pour certains seulement des canaux de l'ensemble de canaux.

2. Un syntoniseur selon la revendication 1, dans lequel la fonction spéciale comprend une fonction d'attente de bulletin d'information routière, pour surveiller la réception d'un bulletin d'information routière, sur la base du signal qui est reçu par les moyens de réception, et pour interrompre la reproduction par les moyens de reproduction et reproduire le bulletin d'information routière lorsque la réception du bulletin d'information routière est détectée.

3. Un syntoniseur selon les revendications 1 ou 2, dans lequel les moyens d'établissement de fonction invalident la fonction spéciale pour le canal dont la section d'entrée est manipulée pendant plus d'une durée prédéterminée.

4. Un syntoniseur selon les revendications 1 ou 2, dans lequel les moyens d'établissement de fonction invalident la fonction spéciale pour le canal dont la variation d'intensité de signal est comprise dans une plage prédéterminée.

5. Un syntoniseur selon les revendications 1 ou 2, comprenant en outre un modulateur de fréquence (80), et dans lequel les moyens d'établissement de fonction invalident la fonction spéciale pour les canaux qui reçoivent un signal provenant du démodulateur de fréquence.
